# EUROPEAN PATENT APPLICATION

(11) **EP 3 567 841 A1**
(43) Date of publication of application: **13.11.2019**
(21) Application number: 18206346.1
(22) Date of filing: 14.11.2018
(51) Int. Cl.: H04N 1/46, B33Y 50/02, B29C 64/106

(54) **METHOD FOR COLOR THREE DIMENSIONAL PRINTING AND COLOR THREE DIMENSIONAL PRINTING DEVICE**

(30) Priority: 08.05.2018 TW 107115505
(71) Applicant: XYZprinting, Inc., New Taipei City 22201 (TW); Kinpo Electronics, Inc., New Taipei City 22201 (TW)
(72) Inventor: HSIEH, Hsin-Ta, 22201 New Taipei City (TW); HUANG, Yu-Ting, 22201 New Taipei City (TW); YUAN, Kuo-Yen, 22201 New Taipei City (TW)
(74) Representative: Emde, Eric

(57) **Abstract**

A method for three dimensional (3D) printing and a 3D printing device are provided. The 3D printing device includes a modeling printing head, a coloring printing head, and a platform. The modeling printing head and the coloring printing head are co-constructed. The three dimensional printing method includes: printing a forming layer and at least one material barrier outside a bounding area of the forming layer; calculating multiple coloring routes of the coloring printing head according to an edge of the forming layer; converting the coloring routes of the coloring printing head into multiple color-passing routes of the modeling printing head; calculating multiple detour routes of the modeling printing head according to the color-passing routes of the modeling printing head.

## Description

### BACKGROUND OF THE INVENTION

### Field of the Invention

The invention relates to a three dimensional (3D) printing technology, and particularly relates to a method for 3D printing and a 3D printing device.

### Description of Related Art

Different methods for constructing physical 3D models using additive manufacturing (AM) technology such as layer-by-layer construction models have been proposed one after another. The AM technology generally uses 3D model design information constructed by software such as computer-aided design (CAD) to convert into multiple thin (quasi-two-dimensional) cross-sectional layers that are continuously stacked.

Currently, many ways have been developed to form multiple thin cross-sectional layers. For example, after a forming material is sprayed or extruded onto a platform according to an information of the foregoing thin cross-sectional layers, the forming material is hardened to form thin cross-sectional layers, and a 3D object may be formed after layer-by-layer stacking. In addition, the printing device may be further equipped with a coloring printing head to facilitate coloring of the thin cross-sectional layers or the 3D object during or after a manufacturing process of the 3D object. Therefore, how to let object printing and coloring actions be smoothly executed respectively during the manufacturing process without affecting each other, is actually a problem that needs to be considered by the relevant technical personnel.

### SUMMARY OF THE INVENTION

The invention provides a method for 3D printing and a 3D printing device, wherein a modeling printing head and a coloring printing head having synchronous displacement may enable at least one material barrier to clean the modeling printing head through adjusting a travelling route of the modeling printing head, and prevent the modeling printing head on a non-coloring route from passing over a 3D object, thereby preventing the 3D object from being affected by a forming material in the modeling printing head when the coloring printing head performing coloring passes through a forming layer.

A method for 3D printing of the invention is applicable to a 3D printing device. The 3D printing device includes a modeling printing head, a coloring printing head, and a platform. The modeling printing head prints out forming layers on the platform, and the coloring printing head colors in the forming layer. The modeling printing head and the coloring printing head are co-structured to form a printing head group. The method for 3D printing includes the following steps: printing a forming layer and at least one material barrier outside a bounding area of the forming layer; calculating multiple coloring routes of the coloring printing head according to an edge of the forming layer when calculating the routes of the printing head group of a coloring operation; converting the coloring routes of the coloring printing head into multiple color-passing routes of the modeling printing head; calculating multiple detour routes of the modeling printing head according to the color-passing routes of the modeling printing head, wherein each of the detour routes is not a shortest route between an end point of the corresponding color-passing route to a start point of a next color-passing route, and one of each of the detour routes and the corresponding color-passing route passes at least one location of the at least one material barrier; and controlling an operation of the printing head group according to the modeling printing head traveling through the color-passing routes and the detour routes, to perform the coloring operation by the coloring printing head in the forming layer.

A 3D printing device of the invention includes a modeling printing head, a coloring printing head, a platform and a processor. The modeling printing head and the coloring printing head are co-structured to form a printing head group. The modeling printing head prints out a forming layer on the platform. The processor controls the modeling printing head to print the forming layer and prints at least one material barrier outside a bounding area of the forming layer. When the processor calculates routes of the printing head group of a coloring operation, calculates multiple coloring routes of the coloring printing head according to an edge range of the forming layer, converts the coloring routes of the coloring printing head into multiple color-passing routes of the modeling printing head according to a spacing between the modeling printing head and the coloring printing head, calculates multiple detour routes of the modeling printing head according to color-passing routes of the modeling printing head. Each of the detour routes is not a shortest route between an end point of the corresponding color-passing route to a start point of the next color-passing route, and one of each of the detour routes and the corresponding color-passing routes passes at least one location of the at least one material barrier. The processor controls an operation of the printing head group according to the modeling printing head traveling through the color-passing routes and the detour routes, to perform the coloring operation by the coloring printing head in the forming layer.

Based on the foregoing, since the 3D printing device of the exemplary embodiment has a modeling printing head and a coloring printing head that moves synchronously, it is necessary to divide the 3D printing operation and the coloring operation when constructing the 3D object, and the 3D printing operation is usually completed before the coloring operation. While performing the coloring operation, in order to prevent the 3D object from being affected by the forming material in the modeling printing head when the coloring printing head performing coloring travels through the forming layer (for example, dripping the forming material from the modeling printing head to the forming layer), when calculating the routes of the modeling printing head and the coloring printing head during the coloring operation, the exemplary embodiment adjusts the traveling route of modeling printing head to allow the modeling print head to pass through the material barrier and prevent the modeling printing head on the non-colored routes from passing over the 3D object, thereby reducing the probability of the modeling printing head dripping material onto the 3D object. The forming material of the modeling printing head may be attached to the material barrier due to contact with the material barrier, that is, the material barrier provides scraping and cleaning actions to the modeling printing head, so that when coloring, the forming material of the modeling printing head is effectively prevented from falling onto the forming layer to affect the print quality of the 3D object.

To make the above features and advantages of the invention more comprehensible, several embodiments accompanied with drawings are described in detail as follows.

### BRIEF DESCRIPTION OF THE DRAWINGS

FIG. 1 is a partial schematic view of a 3D printing device according to an exemplary embodiment of the invention.
FIG. 2 is a partial top schematic view of a 3D printing device.
FIG. 3 is a flow chart of a method for 3D printing according to an exemplary embodiment of the invention.
FIG. 4 is a schematic view of coloring routes of a coloring printing head 132, and color-passing routes and detour routes of a modeling printing head 131 in step S320 to step S340.
FIG. 5 is a detailed flow chart of step S340.
FIG. 6 is a schematic view of detour routes of another exemplary embodiment of the invention.

### DETAILED DESCRIPTION OF DISCLOSED EMBODIMENTS

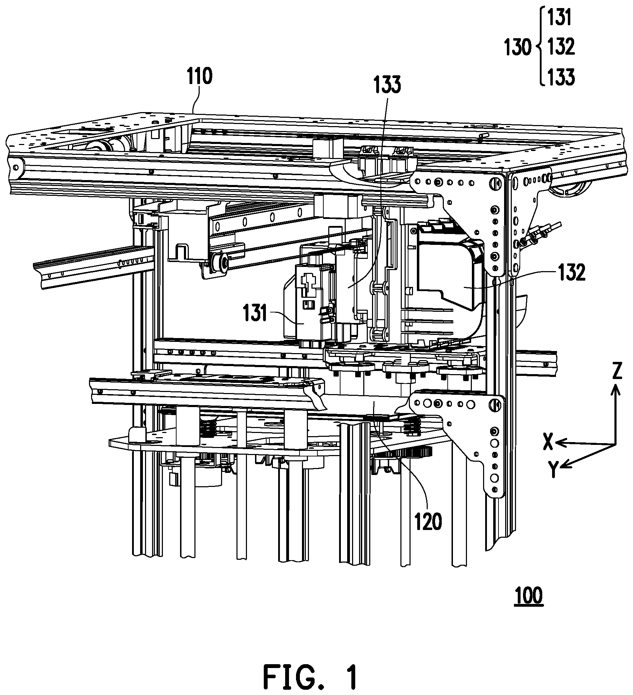

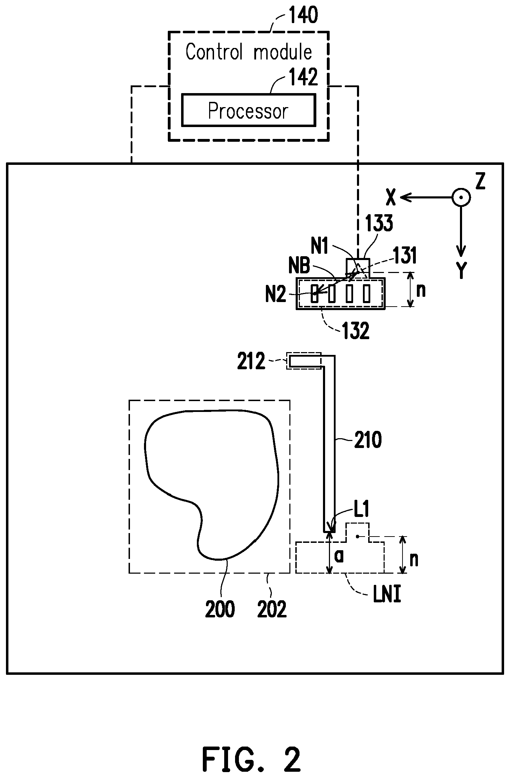

FIG. 1 is a partial schematic view of a 3D printing device 100 according to an exemplary embodiment of the invention. FIG. 2 is a partial top schematic view of a 3D printing device. Referring to both FIG. 1 and FIG. 2, in the exemplary embodiment, the 3D printing device 100 includes a frame 110, a platform 120, a printing component 130 and a control module 140 (shown in FIG. 2). The 3D printing device 100, for example, is a fused deposition modeling (FDM) device. A modeling printing head 131 of the printing component 130 can print out a forming layer 200 layer-by-layer on the platform 120, thereby stacking a 3D object. The printing component 130 further includes a coloring printing head 132, wherein for example, is an inkjet head used for coloring forming layers or 3D objects.

A method for 3D printing of the exemplary embodiment collocates with right-angled coordinates X-Y-Z to define and describe a configuration and an action of a related component more clearly. In this case, the platform 120 has an X-Y plane, and a multi-layer forming layer stacks the 3D object along a positive Z-axis direction, but the invention is not limited thereto. In other words, the configuration and action between components are in a relative state, when used in different coordinate systems, there are of course different ways of description, but does not affect the corresponding relationship between the components.

The modeling printing head 131 and the coloring printing head 132 of the exemplary embodiment form a printing head group to move synchronously in an interior space of the frame 110. Further, as shown in FIG. 1 and FIG. 2, the printing component 130 further includes a moving component 133 which may be movably assembled to the frame 110 and electrically connected to the control module 140. The control module 140 includes a processor 142 and a memory of related commands for storing or temporarily storing the method for 3D printing of the exemplary embodiment of the invention. The modeling printing head 131 and the coloring printing head 132 are jointly assembled on the moving component 133, thus both move along with the moving component 133 within the frame 110. In other words, the modeling printing head 131 and the coloring printing head 132 are disposed on the same moving component 133 to form a co-construction structure, that is, only a single driving means (only driving the moving component 133) can synchronously move the modeling printing head 131 and the coloring printing head 132 (can also be regarded as no relative movement exists between the two). In this way, when the coloring printing head 132 colors the forming layer or the 3D object, the modeling printing head 131 will also follow by traveling above the forming layer or the 3D object (that is, over a direction along a Z-axis). When the modeling printing head 131 just finishes printing the forming layer or the 3D object, a residual forming material will also exist on the inside of the modeling printing head 131. Therefore, as described above, when the modeling printing head 131 passes through the printed forming layer or the 3D object, the residual forming material may have a possibility of dripping or dropping onto the printed forming layer or the 3D object.

In order to prevent the above residual forming material from affecting a quality of a printing target, the method for 3D printing and the corresponding 3D printing device provided in the exemplary embodiment may, when the coloring printing head is moving, apart from cleaning the modeling printing head through the material barrier, try to prevent the modeling printing head on non-colored routes from passing over the 3D object when calculating a displacement route of the modeling printing head, thereby trying to prevent the quality of the forming layer or the 3D object from being affected due to the above reason.

The method for 3D printing of the exemplary embodiment may be implemented after a 3D model is completed, that is, after construction of the 3D object model is completed by a computer-aided design method, the 3D method may be used for cut layer analysis. In the process of analyzing multiple forming layers, the processor 142 in the control module 140 can provide action commands of the 3D printing device 100 when performing an entity printing according to simulating an actuation mode of the modeling printing head 131, the coloring printing head 132 and the moving component 133. In another exemplary embodiment, the 3D object model may also perform an analyzing action by a processor of another computer device or a non-3D printing device. After the analysis is completed and action commands are generated, the control module 140 of the 3D printing device 100 is further imported to perform the entity printing action.

Referring to FIG. 2, when the exemplary embodiment prints the forming layer 200, at least one material barrier 210 is formed together outside a bounding area 202 of the forming layer 200, and after the forming layer 200 and the material barrier 210 are completed, a coloring action of a coloring region is performed. Since a height of the material barrier is just enough to scrape the residual forming material on the modeling printing head 131, when the exemplary embodiment calculates the routes of the modeling printing head and the coloring printing head of the coloring operation, the exemplary embodiment adjusts a traveling route of the modeling printing head to allow the modeling printing head to pass through the material barrier for removing the residual forming material, and prevent the modeling printing head on the non-coloring routes from passing over the 3D object, thereby reducing the probability of the modeling printing head dripping material on the 3D object. The so-called "bounding area" refers to a rectangular block of a smallest rectangular body that may frame the entire 3D object to be printed by orthographic projection on the X-Y plane. Each side of the smallest rectangular body is at least parallel to one of an X-axis, a Y-axis, or a Z-axis. The bounding area may be larger than a peripheral outline (herein, referred to as an edge of the forming layer) of the forming layer 200. For example, when a lower bottom surface of a cone is the 3D object to be printed, the forming layer of the bottom surface is a circular shape with a largest diameter among all the cut layers, and the forming layer more to the top is a circular shape with a smaller diameter. The bounding area is equivalent to a rectangular block (in this case, a square) constructed with a circular diameter as a side length of the bottom surface of the forming layer, and the rectangular block exactly frames a circular shape of the bottom surface of the forming layer. Regarding the description of the forming layer more to the top, the bounding area will be larger than the circular shape of the forming layer, that is, the side length of the bounding area and the circular shape of the forming layer still have an interval distance. The purpose of setting the bounding area is to facilitate the control module 140 in the 3D printing device to determine whether the printing component 130 is located over the forming layer 200 in the current layer, and more importantly, does not affect the completed forming layer underneath. For example, when the printing module 130 is outside the bounding area, indicating that not only is the printing module 130 not over the forming layer 200 in the current layer, and also does not affect the completed forming layer underneath (for example, a bottom surface previously formed underneath). In addition, the edge of the forming layer 200 does not limit the shape thereof due to the appearance of the 3D object. Therefore, the bounding area will help to simplify the route planning or performing related operations of the control module 140 for the printing component 130.

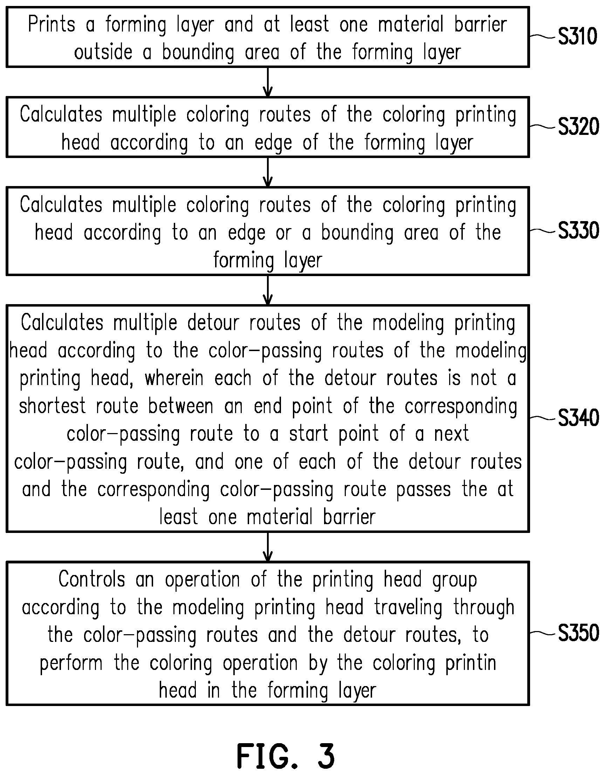

FIG. 3 is a flow chart of a method for 3D printing according to an exemplary embodiment of the invention. Herein, the related prerequisites of the exemplary embodiment of the invention are set in advance. An operational direction of one of the action commands of the modeling printing head and the coloring printing head of the exemplary embodiment when performing the printing operation and/or the coloring operation heads along a direction of an X-axis, and allows the modeling printing head and the coloring printing head to return to the start point of the next action command after completing the current action command. In order to allow the modeling printing head to travel pass the material barrier 210 during the coloring operation, the material barrier 210 of the exemplary embodiment is mainly disposed on a right side of the bounding area 202, applying the exemplary embodiment can arbitrarily dispose the material barrier 210 in a vicinity of the bounding area 202 (for example, left, above, and below the bounding area 202) according to the requirements thereof, and is not limited to the exemplary embodiment.

Referring to both FIG. 2 and FIG. 3, in step S310, when the processor 142 of the control module 140 prints the forming layer 200 by controlling the modeling printing head 131, prints at least one material barrier together (herein, the material barrier 210 is used as an example) outside the bounding area 202 of the forming layer 200. The printing steps of the forming layer 200 are briefly described below. Firstly, the control module 140 obtains a model information of the 3D object and analyzes the model information as forming layer information. The so-called "forming layer" is a conversion of a design information of a software-constructed 3D model into multiple thin (quasi-two-dimensional) cross-sectional layers that are continuously stacked. Then, the forming layer is analyzed and the processor 140 drives the 3D printing device 100 to perform printing according to corresponding commands generated after the analysis, to print the forming layer 200 and the material barrier 210. People applying the exemplary embodiment may arbitrarily adjust the order of printing the forming layer 200 and the material barrier 210, that is, the forming layer 200 and the material barrier 210 may be printed simultaneously through the modeling printing head 131, or one of the forming layer 200 and the material barrier 210 may be printed first, and then the other is printed.

A configuration location of the material barrier 210 may set the location of the material barrier according to a configuration relationship between the modeling printing head 131 and the printing head group. For example, a distance a between a lower edge of the bounding area 202 and a lowermost portion L1 of the material barrier 210 should be less than or equal to a distance n between a center point N1 of the modeling printing head 131 and the lowermost portion of the coloring printing head 132 in the printing head group. Therefore, when the moving component 133 loading the modeling printing head 131 and the coloring printing head 132 is located at a location LN1 (shown by dotted lines) in FIG. 2 to perform a first action command of the coloring operation, the modeling printing head 131 may be allowed to pass through the material barrier 210 to scrape off residual material. In addition, the control module 140 may also configure a start point of the action command near a location of the material barrier so that when performing each action command of the coloring operation, all action commands will allow the modeling printing head 131 to pass through the material barrier 210 to scrape off the residual material. A support portion 212 in the material barrier 210 is used for supporting a material barrier body. The application of the exemplary embodiment does not limit a length, a shape and a configuration direction of the support portion 212.

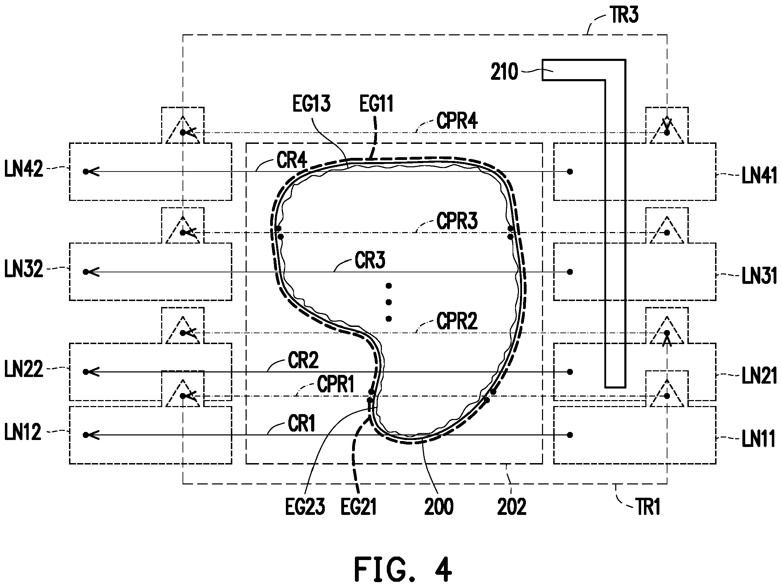

In step S320, the control module 140 calculates multiple coloring routes of the coloring printing head 132 according to an edge of the forming layer 200 or the bounding area when calculating the routes of the printing head group of the coloring operation. FIG. 4 is a schematic view of coloring routes of a coloring printing head 132, and color-passing routes and detour routes of a modeling printing head 131 in step S320 to step S340. The coloring operation is mainly to color (for example, coloring by the method of ink jet) the forming layer 200 by the coloring printing head 132. Therefore, the control module 140 will calculate or obtain multiple coloring routes (for example, solid line arrows CR1 to CR4 in FIG. 4) of the coloring printing head 132 in advance. The so-called "coloring routes" of the exemplary embodiment is to allow the coloring printing head 132 to pass over the forming layer 200 (which is also, over a direction along the Z-axis) and perform coloring. In the exemplary embodiment, an "edge of the forming layer 200" may be a closed curve presented by the forming layer 200 in FIG. 4. In some exemplary embodiments in line with the invention, the control module 140 may allow each coloring route to be as close as possible to the edge of the forming layer 200 under the premise of "allowing the coloring routes of the coloring printing head 132 to be shorter", thereby calculating the coloring routes having shorter coloring distances. On the other hand, the exemplary embodiment of the invention may also use the bounding area located outside "the edge of the forming layer 200" as a basis for calculating the coloring routes, that is, the coloring routes of the coloring printing head 132 are calculated according to the bounding area 202 of the forming layer 200. The reason for using the bounding area of the forming layer 200 as a basis for calculating the coloring routes is that the edge of the forming layer 200 may be very complicated (for example, a pentagram shape, or even an edge with multiple concave shapes). Therefore, using the bounding area as a basis for calculating the coloring routes may reduce an operational quantity of the control module 140. In addition, as explained above regarding the bounding area, in addition to making the 3D printing device ensure that the printing component 130 will not be located over the forming layer 200 of the current layer, the use of the bounding area may also ensure that the forming layer completed underneath will not be affected. The exemplary embodiment in FIG. 4 uses the bounding area of the forming layer 200 as an example of a basis for calculating the coloring routes. However, it is apparent to people skilled in the art that using the bounding area as a calculation basis may have lesser quantity of calculation and lesser influence on each forming layer, but the printing time may be longer, and using the edge of the forming layer 200 as a calculation basis may be a shorter path and may shorten printing time, but the quantity of calculation may be larger. People skilled in the art should be able to decide with discretion on which to use. For example, in the case where the foregoing material barrier is used to scrape the residual material, the probability of dripping the residual material is evaluated to be smaller, then the edge of the forming layer 200 is decided to be used as a calculation basis.

For convenience of description, the start points of coloring routes CR1, CR2, CR3, and CR4 in FIG. 4 respectively show locations LN11, LN21, LN31, and LN41 of the moving component 133 of the printing head group, and the end points of the coloring routes CR1, CR2, CR3, and CR4 also respectively show locations LN12, LN22, LN32, and LN42 of the moving component 133 of the printing head group. In the exemplary embodiment, when the moving component 133 provided with the coloring printing head 132 performs the coloring operation according to the coloring route CR1 and arrives at the location LN12 from the location LN11, the moving component 133 moves to the start point (that is, moving the moving component 133 to the location LN21) of the next coloring route (that is, the coloring route CR2). When the moving component 133 provided with the coloring printing head 132 performs the coloring operation according to the coloring route CR3 and arrives at the location LN32 from the location LN31, the moving component 133 moves to the start point (that is, moving the moving component 133 to the location LN41) of the next coloring route (that is, the coloring route CR4). In other words, the start point and the end point of each of the coloring routes are all located outside the edge (in the exemplary embodiment, the bounding area 202 of the forming layer 200) of the forming layer 200.

In step S330 of FIG. 3, the control module 140 converts the coloring routes CR1 to CR4 of the coloring printing head 132 into multiple color-passing routes CPR1 to CPR4 of the modeling printing head 131 according to a spacing between the modeling printing head 131 and the coloring printing head 132. A spacing between the center point N1 of the modeling printing head 131 and setting point N2 of the coloring printing head 132 in the exemplary embodiment is denoted by NB. As seen from FIG. 4, when learning the spacing NB between the modeling printing head 131 and the coloring printing head 132, the coloring routes CR1 to CR4 displace the spacing NB to obtain the color-passing routes CPR1 to CPR4 of the modeling printing head 131. The reason for performing step S330 lies in: the exemplary embodiment is mainly to try to prevent the modeling printing head 131 from passing over the forming layer 200 of the 3D object when performing the coloring operation. Therefore, it is necessary to know that the color-passing routes CPR1 to CPR4 will definitely allow the modeling printing head 131 to pass over the forming layer 200. In addition, after knowing the color-passing routes CPR1 to CPR4, the multiple detour routes of the modeling printing head 131 may also be calculated in the following step S340.

In step S340 of FIG. 3, the processor 142 in the control module 140 calculates multiple detour routes (such as, detour routes TR1 and TR3) of the modeling printing head 131 according to the color-passing routes (such as, CPR1 to CPR4) of the modeling printing head 131. In the exemplary embodiment, when the modeling printing head 131 performs the coloring operation according to the color-passing route CPR1 and arrives at the location LN12 from the location LN11, the modeling printing head 131 will move to the start point (that is, the moving component 133 will be moved to the location LN21) of the next coloring route (such as, the coloring route CR2) whereby the route between the end point of the color-passing route to the start point of the next color-passing route is referred to as the "detour route".

In conventional 3D printing technology, in order to shorten the printing time, usually the detour route is set as the shortest route between the end point of the color-passing route and the start point of the next color-passing route. However, if the detour route is set as the shortest route, the modeling printing head 131 will mostly be located over the forming layer 200 during the coloring operation, causing the forming material in the printing head to drip on the forming layer 200 when the coloring printing head performs coloring. Therefore, in order to avoid the foregoing problem, the "detour route" of the exemplary embodiment is not the shortest route between the end point of the color-passing route and the start point of the next color-passing route, but the "detour route" is designed as far as possible to bypass the forming layer 200 to prevent the modeling printing head 131 from being over the forming layer 200. Also, one of each of the detour routes and corresponding color-passing routes will pass through the material barrier 210 to scrape the residual forming material on the modeling printing head 131. The exemplary embodiment allows each of the color-passing routes CPR1 to CPR4 to pass through the material barrier 210 at the very beginning. In some of the exemplary embodiments, one may learn by experiments or rule of thumb on when the residue on the modeling printing head 131 will drip in order to set a dripping time, and when designing a moving route (including the color-passing routes and detour routes) of the modeling printing head 131 in the coloring operation, allow the modeling printing head 131 to be over the forming layer 200 after passing through the material barrier 210 within the dripping time, and not to allow the modeling printing head 131 to pass over the forming layer 200 at other times. In this way, residue can be prevented from dripping onto the forming layer 200.

In step S350 of FIG. 3, the processor 142 in the control module 140 controls an operation of a printing head group 130 according to the modeling printing head 131 passing through the color-passing routes (such as, CPR1 to CPR4 in FIG. 4) and the detour routes (such as, TR1 and TR3 in the drawings), to perform the coloring operation by the coloring printing head 132 in the forming layer 200. In this way, after the forming layer 200 of the 3D object is printed out, coloring of the forming layer 200 may be further completed.

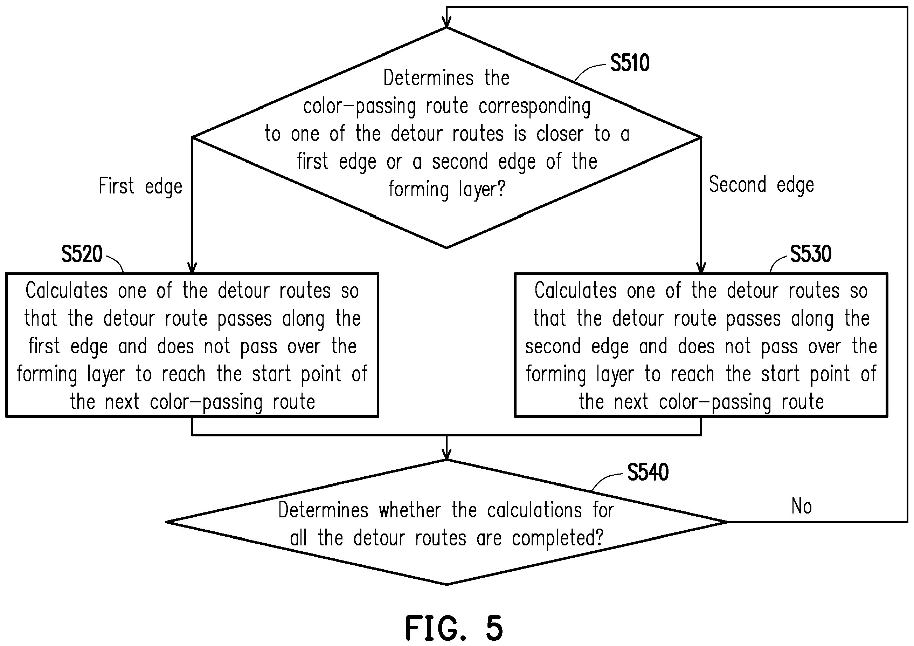

Herein, the detour routes TR1 and TR3 in FIG. 4 will be described as an example of how to calculate and determine the detour routes of the modeling printing head 131. FIG. 5 is a detailed flow chart of step S340. In step S510, the processor 142 determines that the color-passing route corresponding to one of the detour routes is closer to a first edge (e.g, one of the first edges EG11, EG13) or a second edge (e.g., one of the second edges EG21, EG23) of the forming layer 200. The first edges EG11, EG13 of the exemplary embodiment are located on a side of the forming layer 200 divided by the corresponding color-passing route. The second edges EG21, EG23 are located on another side of the forming layer 200 divided by the corresponding color-passing route.

Using an example of the detour route TR1 between an end point of the color-passing route CPR1 to a start point of the color-passing route CPR2, the detour route TR1 corresponds to the color-passing route CPR1, the first edge EG11 is a side edge of the forming layer 200 divided by the corresponding color-passing route CPR1; the second edge EG21 is another side edge of the forming layer 200 divided by the corresponding color-passing route CPR2. Since an average distance of the second edge EG21 to the color-passing route CPR1 is shorter than an average distance of the first edge EG11 to the color-passing route CPR1, the processor 142 determines that the color-passing route CPR1 is closer to the second edge EG21.

When the color-passing route CPR1 is closer to the second edge EG21 of the forming layer 200, the step S510 is then proceeded to step S530, the processor 142 calculates the detour route TR1 so that the detour route TR1 passes along the second edge EG21 and does not pass over the forming layer 220 to reach the start point of the next color-passing route CPR2. In the exemplary embodiment, since the second edge EG21 is closer to a lower edge of the bounding area 202 of the forming layer 200, the detour route TR1 bypasses the lower edge of the bounding area 202, so as to pass along the second edge EG21 and not pass over the forming layer 220 to reach the start point of the next color-passing route CPR2.

In addition, using the example of the detour route TR3 between the end point of the color-passing route CPR3 to the start point of the color-passing route CPR4, the detour route TR3 corresponds to the color-passing route CPR3, a first edge EG13 is a side edge of the forming layer 200 divided by a corresponding color-passing route CPR3; a second edge EG23 is another side edge of the forming layer 200 divided by the corresponding color-passing route CPR3. Since an average distance of the first edge EG13 to the color-passing route CPR3 is shorter than an average distance of the second edge EG23 to the color-passing route CPR3, the processor 142 determines that the color-passing route CPR3 is closer to the first edge EG13.

When the color-passing route CPR3 is closer to the first edge EG13 of the forming layer 200, the step S510 is then proceeded to step S520, the processor 142 calculates the detour route TR3 so that the detour route TR3 passes along the first edge EG13 and does not pass over the forming layer 220 to reach the start point of the next color-passing route CPR4. In the exemplary embodiment, since the first edge EG13 is closer to an upper edge of the bounding area 202 of the forming layer 200, the detour route TR3 bypasses the lower edge of the bounding area 202, so as to pass along the first edge EG13 and not pass over the forming layer 220 to reach the start point of the next color-passing route CPR4.

In step S540, the processor 142 determines whether the calculations for all the detour routes are completed. If the calculations for some of the detour routes are not completed, then returns to step S510 to continue the calculations of the detour routes. If the calculations for all the detour routes are completed, then step S340 of FIG. 3 is finished.

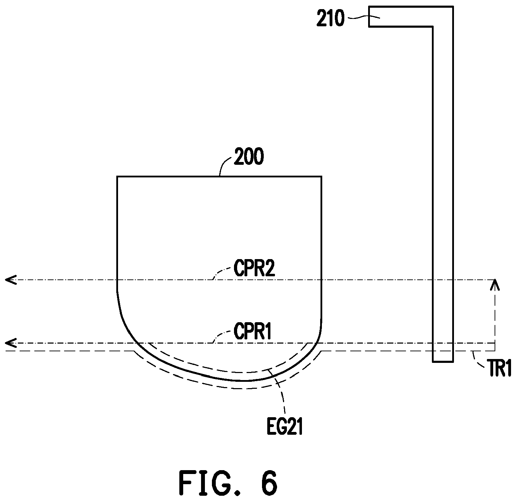

The detour routes disclosed in FIG. 4 are achieved by bypassing the upper or lower edge of the bounding area 202. People who apply the exemplary embodiment may also allow the modeling printing head 131 to travel directly along the first edge or the second edge of the forming layer as the detour route. FIG. 6 is a schematic view of detour routes of another exemplary embodiment of the invention. As shown in FIG. 6, the detour route TR1 travels along the second edge EG21 corresponding to the forming layer 220. In some of the exemplary embodiments, if the first edge or the second edge is too meandering, the control module 140 may also use a designed detour route of the edge, as long as the modeling printing head 131 on the detour route does not pass over the forming layer as far as possible.

In summary of the foregoing, since the 3D printing device of the exemplary embodiment of the invention has the modeling printing head and the coloring printing that moves synchronously, it is necessary to separate the 3D printing operation and the coloring operation when constructing the 3D object, and the 3D printing operation is usually completed before the coloring operation. When performing the coloring operation, in order to prevent the 3D object from being affected by the forming material in the modeling printing head when the coloring printing head performing coloring passes through the forming layer (for example, dripping the forming material from the modeling printing head to the forming layer), when calculating the routes of the modeling printing head and the coloring printing head during the coloring operation, the modeling printing head is allowed to pass through the material barrier and adjust the traveling route of modeling printing head to prevent the modeling printing head on the non-colored routes from passing over the 3D object, thereby reducing the probability of the modeling printing head dripping material onto the 3D object. The forming material of the modeling printing head may be attached onto the material barrier due to contact with the material barrier, that is, the material barrier provides scraping and cleaning actions of the modeling printing head, so that when coloring, the forming material of the modeling printing head is effectively prevented from falling onto the forming layer to affect the print quality of the 3D object.

## Claims

1. A method for three dimensional (3D) printing, applicable to a 3D printing device (100), the 3D printing device (100) comprises a modeling printing head (131), a coloring printing head (132) and a platform (120), the modeling printing head (131) prints out a forming layer (200) at the platform (120), the coloring printing head (132) colors at the forming layer (200), wherein the modeling printing head (131) and the coloring printing head (132) are co-structured to form a printing head group (130), the method for 3D printing comprising:
printing a forming layer (200) and at least one material barrier (210) outside a bounding area (202) of the forming layer (200);
calculating multiple coloring routes (CR1 to CR4) of the coloring printing head (132) according to an edge (EG11, EG21, EG13, EG23) or the bounding area (202) of the forming layer (200) when calculating the routes of the printing head group (130) of a coloring operation;
converting the coloring routes (CR1 to CR4) of the coloring printing head (132) into multiple color-passing routes (CRP1 to CRP4) of the modeling printing head (131);
calculating multiple detour routes (TR1, TR3) of the modeling printing head (131) according to the color-passing routes (CRP1 to CRP4) of the modeling printing head (131), wherein each of the detour routes (TR1, TR3) is not a shortest route between an end point of the corresponding color-passing route (CRP1 to CRP4) to a start point of a next color-passing route (CRP1 to CRP4), and one of each of the detour routes (TR1, TR3) and the corresponding color-passing route (CRP1 to CRP4) passes at least one location of the at least one material barrier (210); and
controlling an operation of the printing head group (130) according to the modeling printing head (131) traveling through the color-passing routes (CRP1 to CRP4) and the detour routes (TR1, TR3), to perform the coloring operation by the coloring printing head (132) in the forming layer (200).

2. The method for 3D printing according to claim 1, wherein the modeling printing head (131) on the detour routes (TR1, TR3) does not pass above the forming layer (200).

3. The method for 3D printing according to claim 1, wherein calculating the detour routes (TR1, TR3) of the modeling printing head (131) comprising:
determining that the color-passing route (CRP1 to CRP4) corresponding to one of the detour routes (TR1, TR3) is closer to a first edge (EG11, EG13) or a second edge (EG21, EG23) of the forming layer (200), wherein the first edge (EG11, EG13) is located on a side of the forming layer (200) divided by the corresponding color-passing route (CRP1 to CRP4), the second edge (EG21, EG23) is located on another side of the forming layer (200) divided by the corresponding color-passing route (CRP1 to CRP4); and
calculating one of the detour routes (TR1, TR3) when the corresponding color-passing route (CRP1 to CRP4) is closer to the first edge (EG11, EG13) so that the detour route (TR1, TR3) passes along the first edge (EG11, EG13) without passing above the forming layer (200) and arrives at the start point of the next color-passing route (CRP1 to CRP4).

4. The method for 3D printing according to claim 3, wherein calculating the detour routes (TR1, TR3) of the modeling printing head (131) comprising:
calculating one of the detour routes (TR1, TR3) when the corresponding color-passing route (CRP1 to CRP4) is closer to the second edge (EG21, EG23) so that the detour route (TR1, TR3) passes along the second edge (EG21, EG23) without passing over the forming layer (200) and arrives at the start point of the next color-passing route (CRP1 to CRP4).

5. The method for 3D printing according to claim 1, wherein the coloring routes (CR1 to CR4) of the coloring printing head (132) convert to the color-passing routes (CRP1 to CRP4) of the modeling printing head (131) according to a spacing between the modeling printing head (131) and the coloring printing head (132),
and the method for 3D printing further comprising:
setting a location of the at least one material barrier (210) according to a setup relationship between the modeling printing head (131) and the printing head group (130).

6. The method for 3D printing according to claim 1, wherein the forming layer (200) and the at least one material barrier (210) completes printing simultaneously.

7. A 3D printing device (100) comprising:
a modeling printing head (131);
a coloring printing head (132), wherein the modeling printing head (131) and the coloring printing head (132) are co-structured to form a printing head group (130);
a platform (120), wherein the modeling printing head (131) prints out a forming layer (200) at the platform (120); and
a processor (142), wherein when the processor (142) controls the modeling printing head (131) to print the forming layer (200), prints at least one material barrier (210) outside a bounding area (202) of the forming layer (200),
when the processor (142) calculates routes of the printing head group (130) of a coloring operation, calculates multiple coloring routes (CR1 to CR4) of the coloring printing head (132) according to an edge (EG11, EG21, EG13, EG23) or the bounding area (202) of the forming layer (200), converts the coloring routes (CR1 to CR4) of the coloring printing head (132) into multiple color-passing routes (CRP1 to CRP4) of the modeling printing head (131) according to a spacing between the modeling printing head (131) and the coloring printing head (132), calculates multiple detour routes (TR1, TR3) of the modeling printing head (131) according to the color-passing routes (CRP1 to CRP4) of the modeling printing head (131), wherein each of the detour routes (TR1, TR3) is not a shortest route between an end point of the corresponding color-passing route (CRP1 to CRP4) and a start point of the next color-passing route (CRP1 to CRP4), and one of each of the detour routes (TR1, TR3) and the corresponding color-passing routes (CRP1 to CRP4) passes at least one location of the at least one material barrier (210), the processor (142) controls an operation of the printing head group (130) according to the modeling printing head (131) traveling through the color-passing routes (CRP1 to CRP4) and the detour routes (TR1, TR3), to perform the coloring operation by the coloring printing head (132) in the forming layer (200).

8. The 3D printing device (100) according to claim 7, wherein the modeling printing head (131) on the detour routes (TR1, TR3) does not pass over the forming layer (200).

9. The 3D printing device (100) according to claim 7, wherein the processor (142) determines the color-passing route (CRP1 to CRP4) corresponding to one of the detour routes (TR1, TR3) is closer to a first edge (EG11, EG13) or a second edge (EG21, EG23) of the forming layer (200), wherein the first edge (EG11, EG13) is located on a side of the forming layer (200) divided by the corresponding color-passing routes (CRP1 to CRP4), the second edge (EG21, EG23) is located on another side of the forming layer (200) divided by the corresponding color-passing routes (CRP1 to CRP4),
when the processor (142) determines the corresponding color-passing route (CRP1 to CRP4) is closer to the first edge (EG11, EG13), calculates one of the detour routes (TR1, TR3) so that the detour route (TR1, TR3) passes along the first edge (EG11, EG13) and does not pass over the forming layer (200) and arrives at the start point of the next color-passing route (CRP1 to CRP4).

10. The 3D printing device (100) according to claim 9, wherein when the processor (142) determines the corresponding color-passing route (CRP1 to CRP4) is closer to the second edge (EG21, EG23), calculates one of the detour routes (TR1, TR3) so that the detour route (TR1, TR3) passes along the second edge (EG21, EG23) and does not pass over the forming layer (200) and arrives at the start point of the next color-passing route (CRP1 to CRP4), wherein the modeling printing head (131) on the detour route (TR1, TR3) does not pass over the forming layer (200).
